# EUROPEAN PATENT APPLICATION

(11) **EP 1 302 980 A1**
(43) Date of publication of application: **16.04.2003**
(21) Application number: 02022620.5
(22) Date of filing: 09.10.2002
(51) Int. Cl.: H01L 21/60, B65D 85/04, B65H 49/38, B65H 75/02

(54) **Spool case for bonding wire, and method of handling spool using same**

(30) Priority: 12.10.2001 KR 2001063053
(71) Applicant: W.C. Heraeus GmbH & Co. KG, 63450 Hanau (DE)
(72) Inventor: You, Chang Man, Bupyung-gu, Incheon, 403-857 (KR); Back, Jung Woo, Yeunsu-go, Incheon, 406-130 (KR); Lim, Hun, Incheon, 402-836 (KR); Chung, So Young, Yongin-si, Kyunggi-do, 449-724 (KR)
(74) Representative: Kühn, Hans-Christian

(57) **Abstract**

A bonding wire spool case, and a method of handling a spool using the spool case is disclosed with a structure capable of effectively preventing the durability and the holding of the spool from being deteriorated due to the repeated coupling and decoupling operations of the spool with respect to the spool holder while preventing the bonding wire from being contaminated and damaged due to the carelessness of the worker. The bonding wire spool case (20) includes a base (22) having a bottom portion (22a) and a sidewall (22b) protruded from the bottom portion (22a). The base mounts a spool (10) wound with a bonding wire (W) thereon. A cover (24) is coupled to the base (22) at the outer surface of the sidewall (22b) of the base to prevent an alien material such as dust from being introduced. The sidewall (22b) of the base (22) is partially provided with an opening portion (22c). A slide coupling member (26) is internally formed at the base (22) such that the slide coupling member (26) is fitted to the flange portion (10') of the spool (10) when the spool slides inward through the opening portion (22c).

## Description

### BACKGROUND OF THE INVENTION

### (a) Field of the Invention

The present invention relates to a spool case for storing and carrying a bonding wire of a wire bonding assembly used in manufacturing a semiconductor chip package and a method of handling a spool using the same and, more particularly, to a bonding wire spool case and a method of handling a spool using the same which can effectively prevent the durability and the holding of the spool from being deteriorated due to the repeated coupling and decoupling operations of the spool with respect to the spool holder, and prevent the bonding wire from being contaminated and damaged due to the carelessness of the worker.

### (b) Description of the Related Art

Generally, a wire bonding assembly is a device for electrically connecting a lead of a lead frame to a bonding pad of a semiconductor chip bearing an electrical characteristic by way of a conductive wire such as a high purity platinum Pt wire or an aluminum wire.

The wire bonding assembly is usually provided with a spool, a spool holder, a wire feed guider, a wire clamp, and a capillary. A conductive wire is wound on the spool, and the spool is fitted to the spool holder. The conductive wire is fused by way of the capillary and a torch bar, and welded to the bonding pad of the semiconductor chip and the lead.

In the wire bonding assembly, the spool wound with a conductive metal wire thereon is usually placed within a spool case, and in that state, it is stored and carried while preventing the contamination and damages thereof. Various kinds of spool cases are used for that purpose.

For instance, Japanese Utility Model Publication Number Sho58-41188 discloses a spool case having a base with a protrusion onto which a cylindrical spool is inserted, and a cover coupled to the base to prevent an alien material such as dust from being introduced. The cover is provided with a spool case, which has a depressed portion for receiving the spool in correspondence with the protrusion of the base.

The worker grips the flange portion of the spool by hand, and fits it to the spool holder to bring out the spool from the spool case.

Accordingly, with the handling of the spool, the fingers of the worker contact the surface of the conductive wire. In this case, the wire is contaminated and damaged, and this induces serious device failures during the wire bonding process.

Japanese Patent Publication Laid-open No. 2000-112599 discloses a bonding wire spool case having an interfacial coupling member externally fitted around the spool flange to hold the spool, and a base capable of being elastically transformed. The worker pressurizes both lateral sides of the base while elastically transforming the base to pick out the spool from the spool case.

However, with the spool case disclosed in Japanese Patent Publication Laid-open No. 2000-112599, the base is formed with a material capable of being elastically transformed such that the spool can be separated from the spool case by way of the interfacial coupling member.

Accordingly, in case the base repeatedly suffers the elastic transformation to make coupling or decoupling of the spool, stress is concentrated at a predetermined region of the base due to the elastic transformation. Consequently, the base is stress-damaged while being deteriorated in its durability.

The interfacial coupling member, which is connected to the base in a body to substantially hold the spool, is formed with an elastic plastic material. With the repeated uses, the interfacial coupling member becomes worn out or blunt, and this deteriorates reliability in the spool holding operation.

Furthermore, with the handling of the spool, the worker picks out the cover from the base, and grips the base to mount the spool to the spool holder of the bonding machine. At this time, the worker may carelessly grip both sides of the base. In this case, the spool holding state of the interfacial coupling member is released so that the spool is separated from the base. Consequently, the bonding wire is contaminated, and damaged.

### SUMMARY OF THE INVENTION

It is an object of the present invention to provide a bonding wire spool case and a method of handing a spool using the spool case which can effectively prevent the durability and the holding of the spool from being deteriorated due to the repeated coupling and decoupling operations of the spool with respect to the spool holder, and prevent the bonding wire from being contaminated and damaged due to the carelessness of the worker.

This and other objects may be achieved by a bonding wire spool case and a method of handling a spool using the spool case with the following features.

The bonding wire spool case includes a base having a bottom portion and a sidewall protruded from the bottom portion. The base mounts a spool wound with a bonding wire thereon. A cover is coupled to the base at the outer surface of the sidewall of the base to prevent an alien material such as dust from being introduced. The sidewall of the base is partially provided with an opening portion. A slide coupling member is internally formed at the base such that the slide coupling member is fitted to the flange portion of the spool when the spool slides inward through the opening portion.

The slide coupling member has a guide rail for spacing the spool from the bottom portion of the base by a predetermined distance, and a coupling protrusion protruded form the inner surface of the sidewall to hold the flange portion of the spool together with the guide rail. The slide coupling member may have two or more coupling protrusions. Preferably, three coupling protrusions are provided at the slide coupling member while being positioned at the portions of the sidewall placed at both sides of the opening portion, and at the portion of the sidewall facing the opening portion.

The spool is fitted to the base by way of the guide rail and the coupling protrusions formed at the sidewall of the base. Accordingly, the spool can be handled without directly touching it by hand. The coupling state of the spool is not released unless it is intentionally separated from the base. Furthermore, the spool can be coupled to the base or decoupled from the base without elastically transforming the base. Accordingly, the durability of the spool and the reliability in the spool holding can be prevented from being deteriorated.

The coupling protrusions may be formed with various shapes while being protruded from the sidewall. Furthermore, the coupling protrusions may be integrated into one while being spatially extended.

The portion of the sidewall facing the opening portion is formed with a curvature identical to the spool flange. The cover has a protrusion inserted into the inner diameter portion of the spool mounted to the base such that the central axis of the spool is maintained to be in the horizontal direction.

As the central axis of the spool is maintained to be in the horizontal direction, the bonding wire wound on the spool deals well with its own load, vibration in its movement and other impacts over its entire length so that the unintended winding or releasing of the wire can be effectively prevented.

A prominent portion may be formed at one or more sides of the cover to keep the central axis of the spool to be in the horizontal direction.

Both ends of the bonding wire wound on the spool are attached to the flange portion of the spool by way of a tape. In case the end portion of the bonding wire is attached to the outer surface of the flange portion, a notch is formed at the flange portion to pass the bonding wire. The notch may be formed at the one-sided flange portion, or at the both-sided flange portions.

With the inventive spool case, the spool can be coupled to, or decoupled from the spool holder through sliding the base in the direction perpendicular to the spool holder. In this way, the coupling or decoupling of the spool can be made without directly touching the spool by hand.

Furthermore, separation of the spool from the base due to the carelessness of the worker can be prevented.

### BRIEF DESCRIPTION OF THE DRAWINGS

A more complete appreciation of the invention, and many of the attendant advantages thereof, will be readily apparent as the same becomes better understood by reference to the following detailed description when considered in conjunction with the accompanying drawings in which like reference symbols indicate the same or the similar components, wherein:
Fig. 1 is an exploded perspective view of a spool case with a cover and a base according to a preferred embodiment of the present invention;
Fig. 2 is a perspective view of the base shown in Fig. 1 mounting a spool therein;
Fig. 3 is a partial sectional view of the spool case shown in Fig. 1 illustrating the storage thereof; and
Fig. 4 is a perspective view of the spool case shown in Fig. 1 illustrating the usage thereof.

### DETAILED DESCRIPTION OF THE PREFERRED EMBODIMENTS

Preferred embodiments of this invention will be explained with reference to the accompanying drawings.

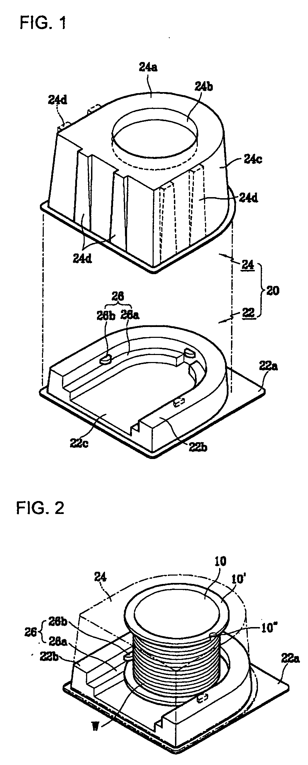

Fig. 1 is an exploded perspective view of a spool case with a cover and a base according to a preferred embodiment of the present invention, and Fig. 2 is a perspective view of the base shown in Fig. 1 mounting a spool therein.

As shown in the drawings, the spool 10, well known in the art, has a cylinder portion (not shown) for winding the bonding wire W thereon, and a pair of flange portions 10' provided at both ends of the cylinder portion. A notch 10" is formed at the flange portion 10' to hold the end portion of the bonding wire W. The bonding wire W passed the notch 10" is fastened to the outer surface of the flange portion 10' by way of a tape (not shown).

The spool case 20 for receiving the spool 10 is provided with a base 22 and a cover 24. The spool case 20 is formed with a material based on synthetic resin such as acryl, polyolefin and styrene.

The base 22 has a bottom portion 22a, and a sidewall 22b protruded from the bottom portion 22a. An opening portion 22c is partially formed at the sidewall 22b. The opening portion 22c makes the spool 10 be slide-inserted into the base 22 through a lateral side thereof.

The portion of the sidewall 22b facing the opening portion 22c is formed with a curvature identical to the spool 10. A slide coupling member 26 is provided at the sidewall 22b. When the spool 10 slides inward through the opening portion 22c, the slide coupling member 26 is coupled to the flange portion 10' of the spool 10. In this preferred embodiment, the slide coupling member 26 has a guide rail 26a for guiding the sliding of the spool 10 in such a state that the spool 10 is spaced apart from the bottom portion 22a of the base 22 by a predetermined distance, and a coupling protrusion 26b for holding the flange portion 10' of the spool 10 together with the guide rail 26a up and down.

The coupling protrusion 26b is formed at the inner surface of the sidewall 22b over the guide rail 26a. The distance of the coupling protrusion 26b and the guide rail 26a is identical to or similar to the thickness of the flange portion 10' of the spool 10. When the spool 10 slides through the opening portion 22c, the flange portion 10' of the spool 10 is fitted between the guide rail 26a and the coupling protrusion 26b, thereby holding the spool 10.

Plural numbers of coupling protrusions 26b may be provided depending upon the kind of the spool 10 and the weight of the bonding wire W wound on the spool 10. The number of coupling protrusions 26b may be established to be two to six.

In this preferred embodiment, three coupling protrusions 26b are formed at the portions of the sidewall placed at both sides of the opening portion 22c and at the portion thereof facing the opening portion 22c, respectively. As the spool 10 is held by the coupling protrusions 26b at three points, the spool holding can be made in a stable manner.

Alternatively, the coupling protrusions 26b may be integrated into one while being spatially extended.

Furthermore, in the absence of the guide rail 26a, the spool 10 may be held by way of the association of the bottom portion 22a and the coupling protrusions 26b. However, with this structure, as the sliding of the flange portion 10' of the spool 10 is made in contact with the bottom portion 22a, shortcomings may be made due to increase in the contact area. Therefore, the spool holding structure is preferably provided with the guide rail 26a.

Meanwhile, the coupling protrusion 26b protruded from the inner surface of the sidewall 22b may be formed with various shapes such as a circle and a rectangle.

The spool 10 is fitted to the base 22 by way of the guide rail 26a and the coupling protrusions 26b formed at the sidewall 22b of the base 22. Accordingly, the spool 10 can be handled without directly touching it by hand. The coupling state of the spool 10 is not released unless it is intentionally separated from the base 22. Furthermore, the spool 10 can be coupled to the base 22 or decoupled from the base 22 without elastically transforming the base 22. Accordingly, the durability of the spool and the reliability in the spool holding can be prevented from being deteriorated.

The cover 24 is fitted to the outer surface of the sidewall 22b from the top of the base 22 to prevent the bonding wire W from being contaminated due to an alien material such as dust. The cover 24 has a top portion 24a, and a protrusion 24b is formed at the center of the top portion 24a. The protrusion 24b is inserted into the inner diameter portion of the spool 10 such that the central axis of the spool 10 can be kept to be in the horizontal direction.

The protrusion 24b is formed with a plane shape of a circle while bearing a diameter identical to or slightly smaller than the spool 10. The length of the protrusion 24b is established to be the same as the height of the sidewall 22b formed at the base 22.

Furthermore, a lateral portion 24c is bent from the top portion 24a. The lateral portion 24c of the cover 24 is cone-shaped while being gradually tapered toward the top portion 24a. A prominent portion 24d is formed at the lateral portion 24c such that it makes the central axis of the spool 10 be maintained to be in the horizontal direction.

The prominent portion 24d may be formed at a lateral side of the cover 24 standing with the opening portion 22c of the sidewall 22b. Alternatively, as indicated by the dotted line in Fig. 1, the prominent portion 24d may be formed at two lateral sides of the cover 10 perpendicular to the opening portion 22c.

Accordingly, the spool 10 wound with the bonding wire W thereon slides into the base 22 through the opening portion 22c such that the flange portion 10' of the spool 10 is fitted between the guide rail 26a and the coupling protrusions 26b. The cover 24 is coupled to the base 22 from the top such that the protrusion 24b of the cover 24 is inserted into the inner diameter portion of the spool 10.

In this state, the spool case 20 is put on a table T such that the prominent portion 24d is directed toward the bottom.

Consequently, as the central axis of the spool 10 is maintained to be in the horizontal direction, the bonding wire W wound on the spool 10 deals well with its own load, vibration in its movement and other impacts over its entire length so that the unintended winding or releasing of the wire can be effectively prevented while prohibiting the rolling of the spool case 20.

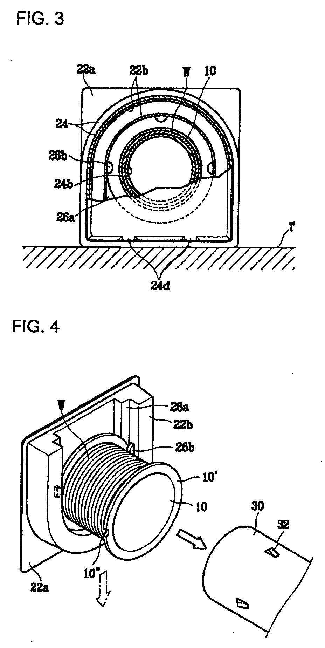

Fig. 3 illustrates the storage of the spool case 20, and Fig. 4 illustrates the usage of the spool case 20.

As shown in Fig. 3, in case the spool 10 is mounted to a spool holder 30 of a wire bonding assembly (not shown), one hand laterally grips the bottom portion 22a of the base 22 and, in that state, the other hand grips the lateral portion of the cover 24. Thereafter, the cover 24 is lifted upward to thereby separate the cover 24 from the base 22. When the opening portion 22c of the base 22 is directed upward, the spool 10 moves in the arrow (solid line) direction, and is fitted to the spool holder 30. At this time, the spool 10 is fixed by a spool fixation member 32 of the spool holder 30.

Thereafter, the base 22 is pulled downward in the direction perpendicular to the spool mounting direction (indicated by the arrow) to thereby release the coupling of the spool 10 to the base 22.

It is possible to pull the base 22 in any one direction perpendicular to the spool holder 32.

With the inventive spool case, the spool is mounted to the base while smoothly sliding in the horizontal direction through the opening portion of the sidewall of the base so that the stress concentration is not made at any portion of the base.

Accordingly, the durability deterioration with the conventional spool case where the coupling or decoupling of the spool is made through elastically transforming the coupling member and the base is prevented.

As any portion is not worn out or stunt at the coupling or decoupling of the spool, reliability in the spool holding can be enhanced.

When the spool is mounted to the base, the conventional spool case is vibrated in the weighted direction of the spool. With the inventive spool case, such a vibration can be prevented. The bonding wire wound on the spool is a extremely minute wire of about 20 µm. Such a minute wire is correctly wound on the spool according to the programmed procedure of the computer. Therefore, the state of the bonding wire wound on the spool can be maintained in a stable manner.

The spool case is extensively used in various kinds of wire bonding assemblies irrespective of the length of the spool holder or the presence of the spool fixation member.

With the inventive spool case, when the worker grips the base to separate the cover form the base or to mount the spool to the spool holder of the wire bonding assembly, the spool holding of the slide coupling member is not released due to the carelessness of the worker. Accordingly, the contamination and damages of the bonding wire pursuant to the separation of the spool from the base can be prevented.

While the present invention has been described in detail with reference to the preferred embodiments, those skilled in the art will appreciate that various modifications and substitutions can be made thereto without departing from the spirit and scope of the present invention as set forth in the appended claims.

## Claims

1. A bonding wire spool case comprising:
a base having a bottom portion and a sidewall protruded from the bottom portion, the base mounting a spool wound with a bonding wire thereon; and
a cover coupled to the base at the outer surface of the sidewall of the base to prevent an alien material such as dust from being introduced;
wherein the sidewall of the base is partially provided with an opening portion, and a slide coupling member is internally formed at the base such that the slide coupling member is fitted to the flange portion of the spool when the spool slides inward through the opening portion.

2. The bonding wire spool case of claim 1 wherein the slide coupling member has a guide rail for spacing the spool from the bottom portion of the base by a predetermined distance, and a coupling protrusion protruded form the inner surface of the sidewall to hold the flange portion of the spool together with the guide rail.

3. The bonding wire spool case of claim 2 wherein the slide coupling member has two or more coupling protrusions.

4. The bonding wire spool case of claim 3 wherein the spool is held by three coupling protrusions at three points.

5. The bonding wire spool case of claim 4 wherein the three coupling protrusions are positioned at the portions of the sidewall placed at both sides of the opening portion, and at the portion of the sidewall facing the opening portion.

6. The bonding wire spool case of claim 1 wherein the portion of the sidewall facing the opening portion is formed with a curvature identical to the spool flange.

7. The bonding wire spool case of claim 1 wherein the cover has a protrusion inserted into the inner diameter portion of the spool mounted to the base such that the central axis of the spool is maintained to be in the horizontal direction.

8. A method of handling a spool using the spool case of any one of claims 1 to 7, the spool being coupled to or decoupled from a spool holder through sliding the base in the direction perpendicular to the spool holder without directly touching the spool by hand.

9. The method of claim 8 wherein the base slides downward in the direction perpendicular to the spool holder.
